# EUROPÄISCHE PATENTANMELDUNG

(11) **EP 4 663 620 A1**
(43) Veröffentlichungstag der Anmeldung: **17.12.2025**
(21) Anmeldenummer: 24181272.6
(22) Anmeldetag: 11.06.2024
(51) Int. Cl.: C04B 37/02, C23F 1/02, H01L 21/48, H01L 23/373, H05K 3/06

(54) **VERFAHREN ZUR HERSTELLUNG EINES METALL-KERAMIK-SUBSTRATS UND METALL-KERAMIK-SUBSTRAT**

(71) Anmelder: Heraeus Electronics GmbH & Co. KG, 63450 Hanau (DE)
(72) Erfinder: WACKER, Richard, 63450 Hanau (DE); BATISTA, Alexandra-Amalia, 307221 Chisoda (RO); BATISTA, Ciprian, 307221 Chisoda (RO); IVAN, Sorin, 307221 Chisoda (RO); LISCA, Bogdan, 307381 Sanmihaiu Roman (RO)
(74) Vertreter: Heraeus IP

(57) **Zusammenfassung**

Die Erfindung betrifft ein Verfahren zur Herstellung eines Metall-Keramik-Substrats, das mit einer Strukturierung und einem Kontaktbereich aufweisend Silber versehen ist, und ein Metall-Keramik-Substrat. Das Verfahren umfasst die Schritte: a) Bereitstellen eines Metall-Keramik-Substrats aufweisend a1) einen Keramikkörper und a2) eine mit dem Keramikkörper flächig verbundene Metallschicht, b) Strukturieren der Metallschicht, c) Abscheiden einer silberhaltigen Schicht auf der strukturierten Metallschicht und d) bereichsweises Abtragen der silberhaltigen Schicht.

## Beschreibung

Die vorliegende Erfindung betrifft ein Verfahren zur Herstellung eines Metall-Keramik-Substrats und ein Metall-Keramik-Substrat.

Metall-Keramik-Substrate spielen eine wichtige Rolle im Bereich der Leistungselektronik. Sie sind ein maßgebliches Element beim Aufbau von elektronischen Bauteilen und sorgen für eine schnelle Ableitung hoher Wärmemengen beim Betrieb dieser Bauteile. Metall-Keramik-Substrate bestehen üblicherweise aus einer Keramikschicht und einer Metallschicht, die mit der Keramikschicht verbunden ist.

Zur Verbindung der Metallschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund erhitzt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

In einem alternativen Verfahren können Metallfolien bei Temperaturen von etwa 650 bis 1000°C mit Keramikkörpern verbunden werden, wobei ein spezielles Lot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Metallfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper zuverlässig zu fügen. Alternativ dazu können auch silberfreie Lote zur Verbindung von Metallfolien mit Keramikkörpern zum Einsatz kommen. Diese Lote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat.

Beim Aufbau von elektronischen Bauteilen werden Metall-Keramik-Substrate üblicherweise mit einem Halbleiterbauelement bestückt. Für die Bestückung des Metall-Keramik-Substrats mit einem Halbleiterbauelement ist es in der Regel erforderlich, dass der mit dem Halbleiterbauelement zu bestückende Bereich des Metall-Keramik-Substrats mit einem silberhaltigen Kontaktbereich versehen ist. Durch die Bereitstellung des silberhaltigen Kontaktbereichs wird eine leichtere Anbindung des Halbleiterbauelements mit dem Metall-Keramik-Substrat durch gängige Verfahren wie Sintern oder Löten ermöglicht. Zur Schaffung des Kontaktbereichs wird das Metall-Keramik-Substrat in der Regel zunächst bereichsweise mit einer Ätzlösung behandelt, um eine gewünschte Strukturierung auszubilden. Danach wird der Kontaktbereich vorgesehen, indem bereichsweise eine silberhaltige Beschichtung auf der Oberfläche des strukturierten Metall-Keramik-Substrats erzeugt wird. Hierzu wird auf die Oberfläche des strukturierten Metall-Keramik-Substrats üblicherweise zunächst eine Maskierung aufgebracht, um Bereiche, die nicht mit der Beschichtung versehen werden sollen, zu schützen. In einem nächsten Schritt erfolgt die Schaffung der silberhaltigen Beschichtung, zum Beispiel durch chemische oder physikalische Verfahren. Anschließend wird dann die Maskierung entfernt. Die Schritte der Maskierung der Oberfläche des strukturierten Metall-Keramik-Substrats und der Entfernung der Maskierung sind technisch anspruchsvoll und daher regelmäßig Quellen für Defekte im fertigen Metall-Keramik-Substrat.

Es besteht daher Bedarf an einem vereinfachten Verfahren zur Herstellung eines Metall-Keramik-Substrats, das mit einer Strukturierung und einem Kontaktbereich aufweisend Silber versehen ist.

Eine Aufgabe der vorliegenden Erfindung besteht daher darin, ein vereinfachtes Verfahren zur Herstellung eines Metall-Keramik-Substrats, das mit einer Strukturierung und einem Kontaktbereich aufweisend Silber versehen ist, bereitzustellen.

Diese Aufgabe wird gelöst durch das Verfahren von Anspruch 1. Die Erfindung stellt daher ein Verfahren zur Herstellung eines Metall-Keramik-Substrats, das mit einer Strukturierung und einem Kontaktbereich aufweisend Silber versehen ist, bereit, umfassend die Schritte
a) Bereitstellen eines Metall-Keramik-Substrats aufweisend
   a1) einen Keramikkörper und
   a2) eine mit dem Keramikkörper flächig verbundene Metallschicht,
b) Strukturieren der Metallschicht,
c) Abscheiden einer silberhaltigen Schicht auf der strukturierten Metallschicht und
d) bereichsweises Abtragen der silberhaltigen Schicht.

Die Erfindung stellt darüber hinaus ein Metall-Keramik-Substrat bereit, das durch ein solches Verfahren hergestellt ist.

Schritt a) des erfindungsgemäßen Verfahrens umfasst den Schritt: Bereitstellen eines Metall-Keramik-Substrats aufweisend a1) einen Keramikkörper und a2) eine mit dem Keramikkörper flächig verbundene Metallschicht.

Das Metall-Keramik-Substrat umfasst einen Keramikkörper.

Der Keramikkörper ist vorzugsweise ein Körper, der aus Keramik gebildet ist. Der Körper kann eine beliebige Geometrie einnehmen, ist aber vorzugsweise als Quader ausgestaltet. Der Keramikkörper weist Begrenzungsflächen auf, im Falle eines Quaders sechs Begrenzungsflächen. Der Keramikkörper weist vorzugsweise eine Hauptbegrenzungsfläche auf. Als Hauptbegrenzungsfläche wird hierin vorzugsweise die Begrenzungsfläche (ganz besonders bevorzugt die Begrenzungsfläche mit dem größten Flächeninhalt) bezeichnet, die mit der Metallschicht flächig verbunden ist. Als Hauptbegrenzungsfläche wird besonders bevorzugt die Begrenzungsfläche (ganz besonders bevorzugt die Begrenzungsfläche mit dem größten Flächeninhalt) bezeichnet, die mit der Metallschicht, auf der ein Kontaktbereich aufweisend Silber angeordnet ist, flächig verbunden ist. Die Hauptbegrenzungsfläche liegt vorzugsweise in der Haupterstreckungsebene des Keramikkörpers oder verläuft parallel zu dieser. Demnach wird unter Haupterstreckungsebene des Keramikkörpers vorzugsweise eine Ebene verstanden, die parallel zur Hauptbegrenzungsfläche des Keramikkörpers verläuft oder diese umschließt.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siluziumnitridkeramiken und Aluminiumoxidkeramiken (wie zum Beispiel ZTA ("Zirconia Toughened Alumina") -Keramiken) besteht. Gemäß einer weiteren ganz besonders bevorzugten Ausführungsform besteht der Keramikkörper aus (1) wenigstens einem Element, das aus der Gruppe ausgewählt ist, die aus Silizium und Aluminium besteht, (2) wenigstens einem Element, das aus der Gruppe ausgewählt ist, die aus Sauerstoff und Stickstoff besteht, optional (3) wenigstens einem Element, das aus der Gruppe ausgewählt ist, die aus (3a) Metallen der seltenen Erden, (3b) Metallen der zweiten Hauptgruppe des Periodensystems der Elemente, (3c) Zirkonium, (3d) Kupfer, (3e) Molybdän und (3f) Silizium besteht, und optional (4) unvermeidlichen Verunreinigungen. Gemäß noch einer weiteren ganz besonders bevorzugten Ausführungsform ist der Keramikkörper frei von Bismut, Gallium und Zink.

Der Keramikkörper weist vorzugsweise eine Dicke im Bereich von 0,05 - 10 mm, mehr bevorzugt eine Dicke im Bereich von 0,1 - 5 mm und besonders bevorzugt eine Dicke im Bereich von 0,15 - 3 mm auf.

Das Metall-Keramik-Substrat umfasst eine mit dem Keramikkörper flächig verbundene Metallschicht.

Die Metallschicht weist Begrenzungsflächen auf. Die Metallschicht weist vorzugsweise eine Hauptbegrenzungsfläche auf. Als Hauptbegrenzungsfläche wird hierin vorzugsweise die Begrenzungsfläche (ganz besonders bevorzugt die Begrenzungsfläche mit dem größten Flächeninhalt) bezeichnet, die dem Keramikkörper abgewandt ist. Folglich wird als Hauptbegrenzungsfläche vorzugsweise die Begrenzungsfläche (ganz besonders bevorzugt die Begrenzungsfläche mit dem größten Flächeninhalt) bezeichnet, auf der der Kontaktbereich aufweisend Silber angeordnet ist. Die Hauptbegrenzungsfläche liegt vorzugsweise in der Haupterstreckungsebene der Metallschicht oder verläuft parallel zu dieser. Demnach wird unter Haupterstreckungsebene der Metallschicht vorzugsweise eine Ebene verstanden, die parallel zur Hauptbegrenzungsfläche der Metallschicht verläuft oder diese umschließt. Die Hauptbegrenzungsfläche der Metallschicht verläuft vorzugsweise parallel zur Hauptbegrenzungsfläche des Keramikkörpers und ist von dieser besonders bevorzugt beabstandet.

Die Metallschicht umfasst vorzugsweise wenigstens ein Metall, das aus der Gruppe ausgewählt, die aus Kupfer, Aluminium und Molybdän besteht. Gemäß einer besonders bevorzugten Ausführungsform umfasst die Metallschicht wenigstens ein Metall, das aus der Gruppe ausgewählt, die aus Kupfer und Molybdän besteht. Gemäß einer ganz besonders bevorzugten Ausführungsform umfasst die Metallschicht Kupfer. Gemäß einer weiteren bevorzugten Ausführungsform besteht die Metallschicht aus Kupfer und gegebenenfalls unvermeidlichen Verunreinigungen. Gemäß einer weiteren bevorzugten Ausführungsform beträgt der Anteil an Kupfer wenigstens 70 Gewichtsprozent, mehr bevorzugt wenigstens 90 Gewichtsprozent, noch mehr bevorzugt wenigstens 95 Gewichtsprozent und besonders bevorzugt wenigstens 99 Gewichtsprozent, bezogen auf das Gesamtgewicht der Metallschicht (vorzugsweise einschließlich einer gegebenenfalls enthaltenen Verbindungsschicht).

Die Metallschicht weist vorzugsweise eine Dicke im Bereich von 0,01 - 10 mm, besonders bevorzugt eine Dicke im Bereich von 0,03 - 5 mm und ganz besonders bevorzugt eine Dicke im Bereich von 0,05 - 3 mm auf.

Die Metallschicht ist mit dem Keramikkörper vorzugsweise stoffschlüssig verbunden. Gemäß einer bevorzugten Ausführungsform ist die Metallschicht mit dem Keramikkörper über ein DCB (Direct Copper Bonding) -Verfahren verbunden. Gemäß einer weiteren bevorzugten Ausführungsform ist die Metallschicht mit dem Keramikkörper über ein Hartlotverfahren verbunden. Bei dem Hartlotverfahren kann es sich zum Beispiel um ein AMB (Active Metal Brazing) -Verfahren handeln, wobei vorzugsweise silberfreie Hartlote (der Gehalt an Silber beträgt dann zum Beispiel weniger als 1,0 Gewichtsprozent basierend auf dem Feststoffgehalt des Hartlotes) oder silberhaltige Hartlote (der Gehalt an Silber beträgt dann zum Beispiel wenigstens 50 Gewichtsprozent basierend auf dem Feststoffgehalt des Hartlotes) verwendet werden. Folglich kann die Metallschicht auch eine Verbindungsschicht umfassen, die mit dem Keramikkörper in Kontakt steht. Bei der Verbindungsschicht kann es sich zum Beispiel um eine Lotschicht (insbesondere eine Hartlotschicht) oder eine Diffusionsschicht handeln.

Die Metallschicht ist mit dem Keramikkörper flächig verbunden. Dementsprechend ist die Metallschicht flächig vorzugsweise mit der Hauptbegrenzungsfläche des Keramikkörpers verbunden. Die Metallschicht ist vorzugsweise nicht mit der gesamten Hauptbegrenzungsfläche des Keramikkörpers verbunden. Insbesondere kann es vorgesehen sein, dass die Hauptbegrenzungsfläche des Keramikkörpers größer ist als die Fläche der mit dem Keramikkörper verbundenen Metallschicht. In diesen Fällen steht die Hauptbegrenzungsfläche des Keramikkörpers über.

Gemäß einer bevorzugten Ausführungsform umfasst das Metall-Keramik-Substrat eine weitere (zweite) Metallschicht, die flächig mit dem Keramikkörper verbunden ist. Die weitere Metallschicht ist vorzugsweise mit der der Hauptbegrenzungsfläche der Keramik abgewandten (und vorzugsweise zu dieser parallel verlaufenden) Begrenzungsfläche flächig verbunden. Die weitere (zweite) Metallschicht kann wie die (erste) Metallschicht beschaffen sein oder in ihrer Beschaffenheit von der (ersten) Metallschicht abweichen. Zur Beschaffenheit der weiteren (zweiten) Metallschicht wird auf die vorstehenden Erläuterungen zur (ersten) Metallschicht Bezug genommen.

Schritt b) des erfindungsgemäßen Verfahrens umfasst den Schritt: Strukturieren der Metallschicht.

Beim Strukturieren der Metallschicht werden Strukturierungen geschaffen. Unter Strukturierungen werden vorzugsweise Ausnehmungen in der Metallschicht verstanden, um einzelne Abschnitte der Metallschicht voneinander zu trennen und damit elektrisch zu isolieren.

Die Strukturierungen legen daher vorzugsweise Bereiche des Keramikkörpers frei. Derartige Strukturierungen werden üblicherweise durch Ätztechniken erzeugt. Hierzu kann zum Beispiel auf die Metallschicht zunächst eine Ätzmaske aufgebracht werden. Die Ätzmaske dient dazu, die maskierten Bereiche der Metallschicht in einem Ätzschritt vor dem Ätzen zu schützen. Dies stellt sicher, dass nur solche Bereiche der Metallschicht des Metall-Keramik-Substrats für das Ätzen zugänglich sind, die unmaskiert und für eine Strukturierung vorgesehen sind. Folglich ist die Ätzmaske so beschaffen, dass im Ätzschritt kein Ätzen der maskierten Bereiche der Metallschicht erfolgt. Die Art der Ätzmaske ist nicht weiter eingeschränkt. Bei der Ätzmaske kann es sich beispielsweise um eine fachübliche Negativmaske oder Positivmaske handeln. Für die Erzeugung der Ätzmaske können fachübliche Ätzresists zum Einsatz kommen. Diese Ätzresists enthalten vorzugsweise ein härtbares Polymer (zum Beispiel ein lichthärtbares Polymer) und können zum Beispiel als Folie (zum Beispiel als Trockenfilm) oder als Flüssigkeit (zum Beispiel durch Drucken oder Sprühen) auf die Metallschicht aufgebracht werden. Nach dem Aufbringen können die Ätzresists auf eine geeignete Weise behandelt (zum Beispiel durch Lichteinstrahlung gehärtet) werden, um die Ätzmaske zu erhalten. Gemäß einer möglichen Ausführungsform wird auf die Metallschicht des Metall-Keramik-Substrats eine photosensitive Folie aufgebracht, die anschließend an den zu maskierenden Bereichen belichtet wird, um die Ätzmaske zu erhalten. Die unbelichteten Bereiche der photosensitiven Folie können im Anschluss auf fachübliche Weise entfernt werden (zum Beispiel unter Einsatz einer Natriumcarbonatlösung).

Nach dem Aufbringen der Ätzmaske auf die Metallschicht erfolgt vorzugsweise das Ätzen von unmaskierten Bereichen der Metallschicht unter Erhalt einer Strukturierung. Das Ätzen erfolgt vorzugsweise auf fachübliche Weise. Vorzugsweise erfolgt das Ätzen daher mit einer fachüblichen Ätzlösung. Gemäß einer bevorzugten Ausführungsform ist die Ätzlösung aus der Gruppe ausgewählt, die aus FeCl3-Ätzlösungen und CuCl2-Ätzlösungen besteht. Falls erforderlich, kann eine weitere Ätzlösung verwendet werden, zum Beispiel um unmaskierte Bereiche einer optional enthaltenen Verbindungsschicht zu strukturieren. Gemäß einer bevorzugten Ausführungsform kann die weitere Ätzlösung aus der Gruppe ausgewählt sein, die aus Ätzlösungen enthaltend Wasserstoffperoxid und aus Ätzlösungen enthaltend Ammoniumperoxodisulfat besteht. Zum Beispiel kann die weitere Ätzlösung eine Ätzlösung sein, die Ammoniumfluorid und Fluorborsäure (zum Beispiel HBF4) sowie Wasserstoffperoxid und/oder Ammoniumperoxodisulfat enthält.

Vorzugsweise erfolgt nach dem Ätzen von unmaskierten Bereichen der Metallschicht unter Erhalt einer Strukturierung das Entfernen der Ätzmaske. Die Ätzmaske kann auf eine fachübliche Weise entfernt werden. Hierzu kann das Metall-Keramik-Substrat beispielsweise mit einer alkalischen Lösung (zum Beispiel einer 2,5%igen Natriumhydroxidlösung) behandelt werden, um die Ätzmaske zu entfernen.

Schritt c) des erfindungsgemäßen Verfahrens umfasst den Schritt: Abscheiden einer silberhaltigen Schicht auf der strukturierten Metallschicht.

In diesem Schritt wird auf die strukturierte Metallschicht flächig eine silberhaltige Schicht aufgebracht. Das Aufbringen der silberhaltigen Schicht erfolgt dabei vorzugsweise auf die Hauptbegrenzungsfläche der Metallschicht. Gemäß einer bevorzugten Ausführungsform sind wenigstens 50 Prozent, mehr bevorzugt wenigstens 90 Prozent, besonders bevorzugt wenigstens 95 Prozent und ganz besonders bevorzugt wenigstens 99 Prozent der Hauptbegrenzungsfläche der Metallschicht von der silberhaltigen Schicht bedeckt.

Die silberhaltige Schicht umfasst Silber. Der Gehalt an Silber beträgt vorzugsweise wenigstens 50 Gewichtsprozent, mehr bevorzugt wenigstens 80 Gewichtsprozent, noch mehr bevorzugt wenigstens 90 Gewichtsprozent, besonders bevorzugt wenigstens 95 Gewichtsprozent und ganz besonders bevorzugt wenigstens 99 Gewichtsprozent, bezogen auf das Gesamtgewicht der silberhaltigen Schicht. Die silberhaltige Schicht besteht vorzugsweise aus Silber oder einer silberhaltigen Legierung.

Die silberhaltige Schicht kann auf der Metallschicht des Metall-Keramik-Substrats durch unterschiedliche Techniken abgeschieden werden. Die Abscheidung der silberhaltigen Schicht erfolgt vorzugsweise chemisch (zum Beispiel elektrochemisch) oder physikalisch.

Die chemische Abscheidung der silberhaltigen Schicht kann zum Beispiel galvanisch oder stromlos erfolgen. Vorzugsweise erfolgt die chemische Abscheidung der silberhaltigen Schicht stromlos durch Aufbringen einer silberhaltigen Lösung unter einem Ladungsaustausch zwischen den Metallen, wobei Metall der Metallschicht teilweise in Lösung geht, während sich das in Lösung befindliche Silber abscheidet. Gemäß einer bevorzugten Ausführungsform enthält die silberhaltige Lösung ein Silbersalz und besonders bevorzugt Silbernitrat. Gemäß einer besonders bevorzugten Ausführungsform handelt es sich bei der silberhaltigen Lösung um eine saure Lösung von Silbernitrat und besonders bevorzugt um eine salpetersaure Lösung von Silbernitrat.

Die physikalische Abscheidung der silberhaltigen Schicht kann zum Beispiel durch Gasphasenabscheidung erfolgen. Bevorzugte Verfahren zur Gasphasenabscheidung sind dabei insbesondere die Elektronenstrahlabscheidung, die Laserstrahlabscheidung, die Bogenentladungsabscheidung oder das Kathodenzerstäuben.

Schritt d) des erfindungsgemäßen Verfahrens umfasst den Schritt: bereichsweises Abtragen der sillberhaltigen Schicht.

Beim bereichsweisen Abtragen der silberhaltigen Schicht werden Abschnitte der silberhaltigen Schicht entfernt, um wenigstens einen Kontaktbereich aufweisend Silber auszubilden und diesen gegebenenfalls von anderen Kontaktbereichen aufweisend Silber räumlich zu isolieren.

Das bereichsweise Abtragen der silberhaltigen Schicht kann auf eine fachübliche Weise erfolgen.

Vorzugsweise erfolgt das bereichsweise Abtragen der silberhaltigen Schicht durch Eintrag von Energie und besonders bevorzugt durch den Eintrag von Strahlungsenergie. Besonders bevorzugt erfolgt das bereichsweise Abtragen der silberhaltigen Schicht nicht durch chemische Verfahren und ganz besonders bevorzugt nicht durch Verfahren, bei denen Bestandteile der silberhaltigen Schicht durch Kontakt mit einer bei Raumtemperatur und Normaldruck flüssigen Substanz in Lösung gebracht werden.

Gemäß einer bevorzugten Ausführungsform erfolgt das bereichsweise Abtragen der silberhaltigen Schicht durch den gepulsten Laserstrahl eines Ultrakurzpulslasers. Ein Ultrakurzpulslaser ist ein Laser, der Laserpulse mit einer Pulsdauer im Bereich von Pikosekunden ("Pikosekundenlaser") oder Femtosekunden ("Femtosekundenlaser") emittieren kann. Der gepulste Laserstrahl des Ultrakurzpulslasers weist beispielsweise Laserpulse mit einer Pulsdauer im Bereich von Pikosekunden ("Pikosekundenlaser") oder Femtosekunden ("Femtosekundenlaser") auf. Beispielsweise beträgt die Pulsdauer 1 fs bis 100 ps (z.B. 1 bis 100 ps oder 1 bis < 1000 fs).

Bei dem erfindungsgemäßen Verfahren ist nach der Strukturierung der Metallschicht in Schritt b) keine Maskierung der Metallschicht erforderlich, um einen Strukturierungsbereich aufweisend Silber zu erzeugen. Damit entfallen die technisch anspruchsvollen Schritte der Maskierung der Oberfläche des strukturierten Metall-Keramik-Substrats und der Entfernung der Maskierung, die regelmäßig Quellen für Defekte im fertigen Metall-Keramik-Substrat darstellen. Darüber hinaus wird eine Belastung von Abwässern mit den für die Maskierung und Entfernung der Maskierung erforderlichen chemischen Substanzen vermieden und deren umweltgerechte Entsorgung eingespart.

Durch das erfindungsgemäße Verfahren wird ein Metall-Keramik-Substrat erhalten, das mit einer Strukturierung und einem Kontaktbereich aufweisend Silber versehen ist. Der Kontaktbereich dient vorzugsweise dazu, die Anbindung eines Halbleiterbauelements auf der Metallschicht zu erleichtern. Halbleiterbauelemente werden vorzugsweise durch Sintern, Löten oder Kleben mit der Metallschicht verbunden. Da insbesondere das Befestigen von Halbleiterbauelementen auf dem Metall der Metallschicht eines Metall-Keramik-Substrats nicht ohne weiteres möglich ist, wird die Metallschicht vorzugsweise mit einem Kontaktbereich versehen.

Das erfindungsgemäß erhaltene Metall-Keramik-Substrat kann insbesondere für Anwendungen in der Elektronik, vor allem für den Bereich der Leistungselektronik, eingesetzt werden.

## Patentansprüche

1. Verfahren zur Herstellung eines Metall-Keramik-Substrats, das mit einer Strukturierung und einem Kontaktbereich aufweisend Silber versehen ist, umfassend die Schritte:
a) Bereitstellen eines Metall-Keramik-Substrats aufweisend
a1) einen Keramikkörper und
a2) eine mit dem Keramikkörper flächig verbundene Metallschicht,
b) Strukturieren der Metallschicht,
c) Abscheiden einer silberhaltigen Schicht auf der strukturierten Metallschicht und
d) bereichsweises Abtragen der silberhaltigen Schicht.

2. Verfahren gemäß Anspruch 1, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

3. Verfahren gemäß Anspruch 1 oder Anspruch 2, **dadurch gekennzeichnet, dass** die Metallschicht Kupfer umfasst.

4. Verfahren gemäß einem der vorangegangenen Ansprüche, **dadurch gekennzeichnet, dass** das bereichsweise Abtragen der silberhaltigen Schicht durch den gepulsten Laserstrahl eines Ultrakurzpulslasers erfolgt.

5. Metall-Keramik-Substrat hergestellt durch ein Verfahren gemäß Anspruch 1.
